# EUROPEAN PATENT APPLICATION

(11) **EP 4 231 090 A1**
(43) Date of publication of application: **23.08.2023**
(21) Application number: 22157166.4
(22) Date of filing: 17.02.2022
(51) Int. Cl.: G02F 1/35, H01S 3/00, H01S 3/23, G02B 6/02, H01S 3/06, H01S 5/42, G03F 7/20, G01B 11/00, G02F 1/365, H01S 3/0941

(54) **A SUPERCONTINUUM RADIATION SOURCE AND ASSOCIATED METROLOGY DEVICES**

(71) Applicant: ASML Netherlands B.V., 5500 AH Veldhoven (NL)
(72) Inventor: NI, Yongfeng, 5500 AH Veldhoven (NL)
(74) Representative: ASML Netherlands B.V.

(57) **Abstract**

Disclosed is a supercontinuum radiation source comprising a pump laser arrangement for generating pump radiation and comprising a plurality of pump laser heads; a radiation combiner for combining the respective pump radiation from each pump laser head, and a non-linear fiber for receiving said pump radiation so as to excite a working medium within the non-linear fiber to generate said supercontinuum radiation. Each pump laser head has dimensions no greater than 5cm in any direction. Alternatively, or in addition the supercontinuum radiation source further comprises a control arrangement for controlling the pump laser arrangement, said control arrangement being configured for non-simultaneous emission of pulses from each pump laser head.

## Description

### FIELD

The present invention relates to a supercontinuum radiation source (e.g., a photonic crystal fiber based supercontinuum radiation source, and in particular a supercontinuum radiation source in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. It would be desirable to improve on present devices for broadband radiation generation.

### SUMMARY

In a first aspect of the invention there is provided a supercontinuum radiation source comprising: a pump laser arrangement for generating pump radiation and comprising a plurality of pump laser heads, each having dimensions no greater than 5cm in any direction; a radiation combiner for combining the respective pump radiation from each pump laser head; and a non-linear fiber for receiving said pump radiation so as to excite a working medium within the non-linear fiber to generate said supercontinuum radiation.

In a second aspect of the invention there is provided a supercontinuum radiation source comprising: a pump laser arrangement for generating pump radiation and comprising a plurality of pump laser heads; a radiation combiner for combining the respective pump radiation from each pump laser head, a non-linear fiber for receiving said pump radiation so as to excite a working medium within the non-linear fiber to generate said supercontinuum radiation; and a control arrangement for controlling the pump laser arrangement, said control arrangement being configured for non-simultaneous emission of pulses from each pump laser head.

Further aspects include a metrology device comprising the supercontinuum radiation source of the first or second aspects, and associated lithographic apparatus and lithocell.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;
- Figure 6 depicts a schematic overview of an alignment sensor apparatus which may comprise a radiation source according to embodiments of the invention;
- Figure 7(a) is a schematic illustration of a supercontinuum radiation source according to a first embodiment, and Figures 7(b) and 7(c) illustrate alternative beam combining arrangements for the supercontinuum radiation source illustrated in Figure 7(a);
- Figure 8 is a schematic illustration of a pump laser head usable in embodiments disclosed herein;
- Figure 9 is a schematic illustration of a supercontinuum radiation source according to a second embodiment;
- Figure 10 is a schematic cross sectional view of a hollow core optical fiber that may form part of a radiation source according to an embodiment in a transverse plane (i.e. perpendicular to an axis of the optical fiber);
- Figure 11 depicts a schematic representation of a radiation source according to an embodiment for providing broadband output radiation; and
- Figures 12 (a) and (b) schematically depict the transverse cross-sections of examples of hollow core photonic crystal fiber (HC-PCF) designs for supercontinuum generation;.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

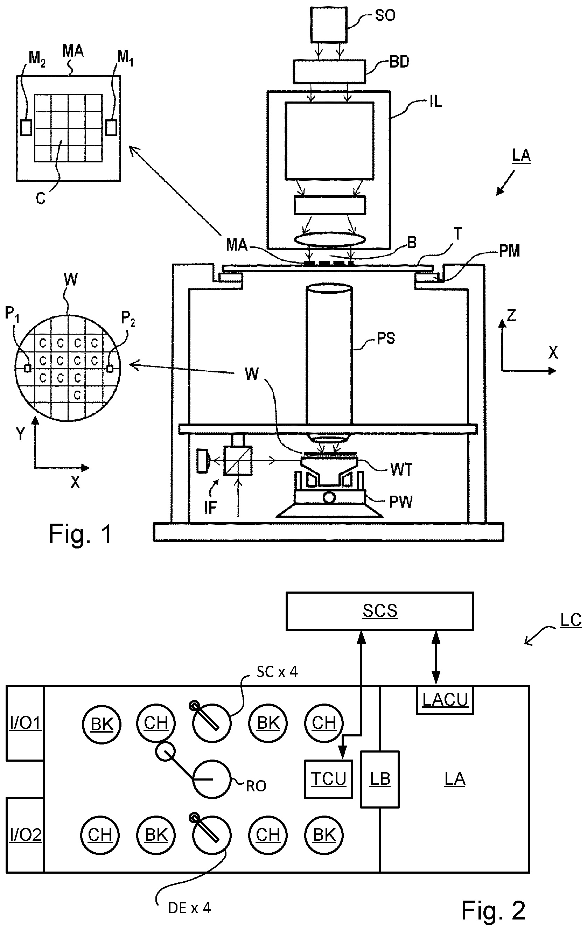

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

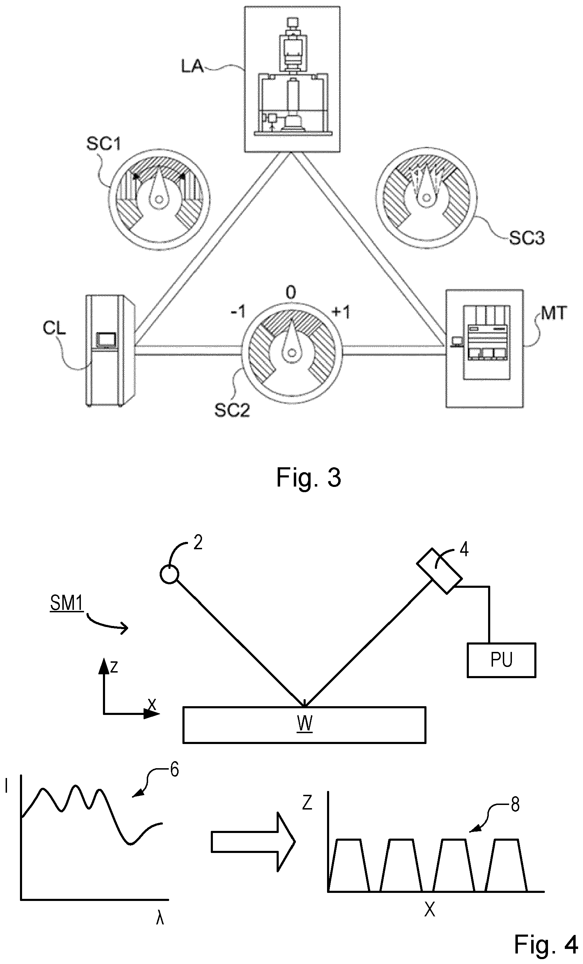

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

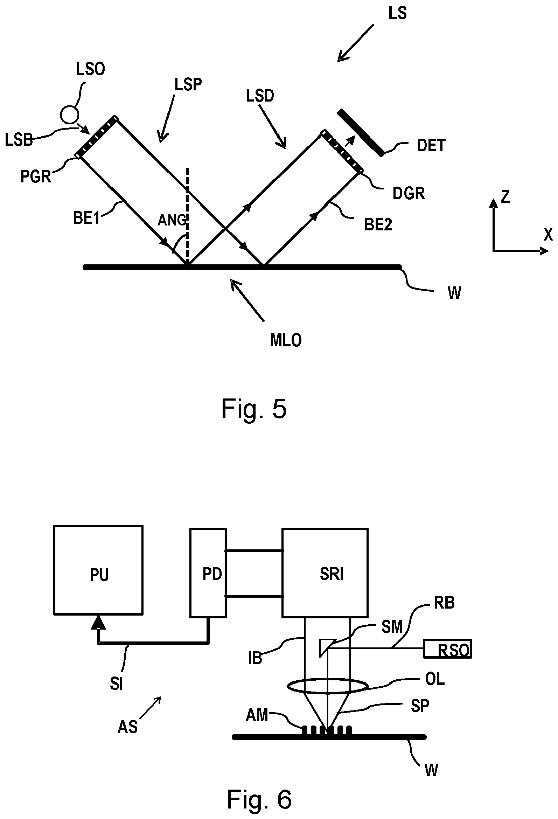

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and demultiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

For optical semiconductor metrology, inspection applications, such as in any of the aforementioned metrology tools, a bright light source which outputs coherent radiation, simultaneously covering a broad wavelength range (e.g., from UV to IR), is often preferred. Such a broadband light source can help improve the flexibility and robustness of applications by allowing wafers with different material characteristics to be optically examined in the same setup/system without a need for any hardware change (e.g., changing a light source so as to have a specific wavelength). Allowing the wavelength to be optimized for a specific application also means that the accuracy of measurements can be further increased.

Gas lasers, which are based on the gas-discharge effect to simultaneously emit multiple wavelengths, can be used in these applications. However, intrinsic issues such as high intensity instability and low spatial incoherence associated with gas lasers can make them unsuitable. Alternatively, outputs from multiple lasers (e.g., solid-state lasers) with different wavelengths can be spatially combined into the optical path of a metrology or inspection system so as to provide a multiple wavelength source. The complexity and high implementation costs, which increases with the number of wavelengths desired, prevents such a solution from being widely used. In contrast, a fiber-based broadband or white light laser, also called a supercontinuum laser, is able to emit radiation with high spatial coherence and broad spectral coverage, e.g., from UV to IR, and therefore is a very attractive and practical option.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

One method for generating broadband radiation may be to broaden high-power narrow band or single frequency input radiation, for example making use of non-linear, higher order effects. The input radiation (which may be produced using a laser) may be referred to as pump laser radiation. Alternatively, the input radiation may be referred to as seed radiation. To obtain high power radiation for broadening effects, radiation may be confined into a small area so that strongly localised high intensity radiation is achieved. In those areas, the radiation may interact with broadening structures and/or materials forming a non-linear medium so as to create broadband output radiation. In the high intensity radiation areas, different materials and/or structures may be used to enable and/or improve radiation broadening by providing a suitable non-linear medium.

In some implementations, the broadband output radiation is created in a photonic crystal fiber. (PCF). In several embodiments, such a photonic crystal fiber has microstructures around its fiber core assisting in confining radiation that travels through the fiber in the fiber core. The fiber core can be made of a solid material that has non-linear properties and that is capable of generating broadband radiation when high intensity pump laser radiation is transmitted through the fiber core. Alternatively a hollow-core photonic crystal fiber (HC-PCF) comprises a central hollow core region and an inner cladding structure surrounding the hollow core, both of which extend axially along the entire fiber. The light guidance mechanism is enabled by the inner cladding waveguide structure, which may comprise, for example, thin-walled glass elements. The radiation is thus confined predominantly inside a hollow core and propagates along the fiber in the form of transverse core modes.

Current commercial supercontinuum light sources typically use a high power ultrashort pulse fiber laser for generating the pump radiation. These pump lasers are relatively expensive. To generate supercontinuum light, the pump laser should generate short pulses (e.g. in the femtosecond fs to picosecond ps range). This requires a high energy per pulse in order to get a relatively high peak power, given a certain repetition rate.

The pump laser for such supercontinuum sources typically consists of mode-locked seed laser, pre-amplifer and power amplifier. To avoid damage, special large mode area fibers are needed in the power amplifer. The cost of the large mode area fiber is high, and its bending property sets a limit on the overall volume of the pump laser. Supercontinuum radiation is typically generated commercially using a pump wavelength at 1030nm or 1064nm; to extend the wavelength range to UV, the nonlinear fiber needs special configuration (e.g., by tapering) or to pump with high pulse energy. This may reduce fiber lifetime. Also, it is often the case that only a small portion of the wavelength range is needed, and the majority of the generated light is therefore thrown away, which is very inefficient.

To address one or more of these issues, a supercontinuum source is proposed comprising: a pump laser arrangement for generating pump radiation and comprising a plurality of pump laser heads having dimensions no greater than 5cm (optionally smaller than 4cm, 3cm, 2cm or 1 cm) in any direction, a radiation combiner for combining the respective pump radiation from each pump laser head, and a non-linear fiber for receiving said pump radiation to excite a working medium within the non-linear fiber to generate said supercontinuum radiation. As an alternative or in addition to each pump laser head having dimensions no greater than 5cm (optionally smaller than 4cm, 3cm, 2cm or 1 cm) in any direction, said supercontinuum source may comprise a control arrangement for the pump laser arrangement configured for non-simultaneous emission of pulses from each pump laser head.

The peak power of each laser head may be greater than 1kW, greater than 5kW, greater than 10kW, greater than 15kW or greater than 20kW.

In an embodiment, each pump laser head may comprise a microchip laser. A microchip laser is an established technology based on a very thin (e.g., solid-state) gain medium within a resonator cavity, the gain medium being pumped by a pump laser. The pump laser may comprise a diode laser; however, other suitable miniaturized laser technologies are possible; e.g., VCSEL (vertical cavity surface emitting laser) or VECSEL (Vertical external cavity surface emitting laser). Alternatively a VCSEL or VECSEL may be used as the pump laser head without additional cavity.

The pump laser arrangement may have, for example, more than 3, more than 4, more than 5, more than 6, more than 10, more than 15, more than 20 or more than 30 pump laser heads.

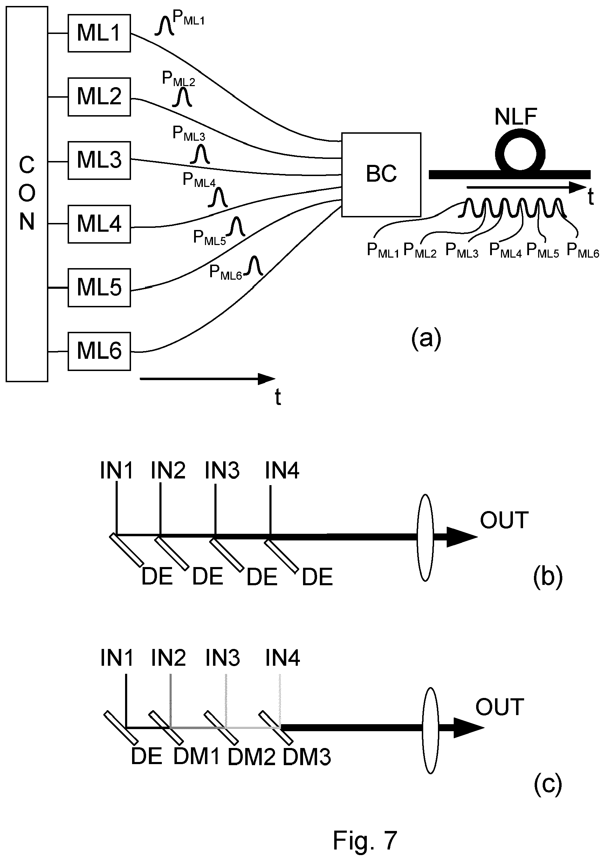

Figure 7(a) is a schematic drawing of a supercontinuum source according to an embodiment. The supercontinuum source comprises a plurality of pump laser heads controlled by a control unit CON. In this specific embodiment, each pump laser head is a microchip laser ML1-ML6 (the number of microchip lasers may of course differ from the six shown here), although other laser technologies may be used for the pump laser heads. The outputs of the microchip lasers ML1-ML6 are combined with combining optics; more specifically in this example transported by a respective fiber to a fiber based beam combiner BC. The combined outputs are then used to pump a working medium within a non-linear fiber NLF (e.g., a hollow core or solid core PCF or any other non-linear medium) to generate a broadband spectrum. For example, the combined outputs may be focused on an input facet of the non-linear fiber NLF. In this way, the radiation source can operate at a relatively high repetition rate, and where each pulse of the microchip lasers ML1-ML6 may be converted into a pulse of supercontinuum radiation.

The process and fiber used to generate broadband light should be such that short pulses of a relatively low pulse energy can be combined and delivered to the fiber for generating supercontinuum radiation. The microchip lasers ML1-ML6 each fire a respective pump pulse P_{ML1}-P_{ML6} non-simultaneously (e.g., sequentially or with staggered timing). This is illustrated in the Figure by the pulses' positions with respect to time axes t (shown pre-combination by beam combiner BC and post-combination by beam combiner BC). It may be that there is (e.g., at least normally) no temporal overlap between pulses from the different microchip lasers. However, for simplicity of design it may be that the microchip laser firing is controlled relatively loosely (exact timing is not crucial), and therefore some pulse overlap is possible. However the control of each microchip laser is such that the pulses are emitted from each microchip laser non-simultaneously, e.g., without synchronization between laser firing. In this way, while the pulse repetition rate of each microchip laser (or more generally pump laser head) may be less than 5MHz or less than 1MHz, the pulse repetition rate of the combined output of the microchip lasers ML1-ML6 (i.e., of the pump laser arrangement overall) may be greater than 1MHz or 10MHz.

The total output power and/or repetition rate of the pump laser arrangement can be controlled or scaled by adding/removing microchip lasers ML1-ML6 to the plurality or array of microchip lasers, or activating/switching on/off individual microchip lasers ML1-ML6 of the plurality/array of microchip lasers.

The different microchip lasers ML1-ML6 may all output radiation of the same wavelength, or one or more of the different microchip lasers ML1-ML6 may emit radiation at different wavelengths. Using multiple wavelengths for the pump radiation can improve overall efficiency of the supercontinuum generation and/or generate different output spectra by integrating over time and/or enabling selection of different output combinations (e.g., via individual control/activation of the microchip lasers ML1-ML6 as just described).

The combining optics may differ from a fiber based beam combiner BC shown in this Figure. Figure 7(b) and 7(c) show two alternative free space optical concepts for combining the outputs of the microchip lasers ML1-ML6. The arrangement in Figure 7(b) comprises a directing element or mirror/prism DE for directing a respective input beam IN1-IN4 from a respective microchip laser into a single beam as illustrated. These directing elements DE are staggered slightly (or are progressively smaller) in a direction perpendicular to the beam propagation direction such that no directing element blocks a previously combined input beam. Such an approach is suitable for input beam IN1-IN4 wavelengths which are all the same, or for which at least one differs.

Figure 7(c) comprises multiple different dichroic mirrors DM1-DM3, each of which transmits wavelength of the beam on its input face (e.g., the wavelength of the previously combined beam(s) but reflects the wavelength of its respective input beam. The first input beam IN1 may be directed with a directing element DE or conventional mirror/prism. By way of example, dichroic mirror DM1 may transmit at the wavelength of input beam IN1, and reflect at the wavelength of input beam IN2. Similarly, dichroic mirror DM1 may transmit at the wavelength of combined input beams IN1, IN2 and reflect at the wavelength of input beam IN3.

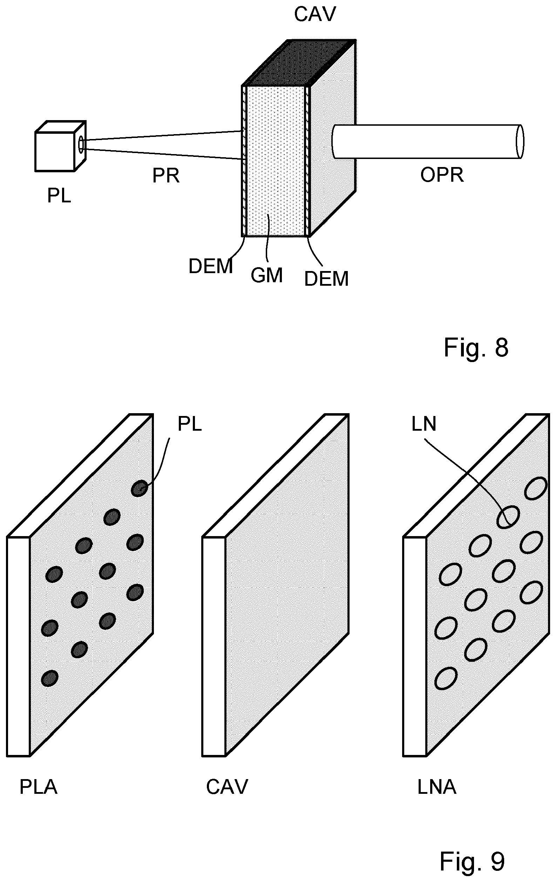

Figure 8 is a more detailed schematic diagram of a single pump laser head, more specifically a single microchip laser or microchip laser head. The microchip laser comprises a pump laser PL, such as a laser diode or VCSEL, which outputs pump radiation PR to a laser cavity CAV, so as to generate output pump radiation OPR for combination with outputs from other microchip lasers. The laser cavity CAV may be defined by a pair of dielectric mirrors DEM separated by a (e.g., solid state) gain medium GM.

Figure 9 illustrates an embodiment of the pump laser arrangement for further improving integration and space efficiency. In this embodiment, the pump laser heads are integrated into an integrated array (e.g., a 1D or 2D array). In the specific example shown, an array PLA of pump lasers PL (e.g., laser diodes or VCSELs/VECSELs) are provided, e.g., arranged or integrated on a substrate (laser diodes or VCSELs/ VECSELs can be integrated at wafer level). The gain medium and cavity CAV may comprise (as shown here) a common gain medium and cavity CAV for all of the pump lasers PL of the array PLA. Alternatively the embodiment may comprise individual but integrated gain mediums and cavities CAV for a respective each microchip seed lasers MSL or group thereof. The pump radiation from each pump laser PL can then be collected by a respective lens LN (e.g., microlens) of (e.g., fiber-coupled) lens array LNA or microlens array for combination by beam combining optics (not shown).

The concepts disclosed herein enable a very compact design at low cost compared to present pump laser arrangements. In addition, each laser head beam can be individually chosen and controlled. As such, it provides flexibility for different applications in a common design. For example, if more power is needed, all the pump laser heads can be set to output at the same wavelength. As there are multiple lasers, the effective repetition rate is also multiple times that of the repetition rate of each individual laser, thus helping to reduce integrated noise. If for different applications, the required wavelength range is different, different laser heads can be configured to have different wavelengths.

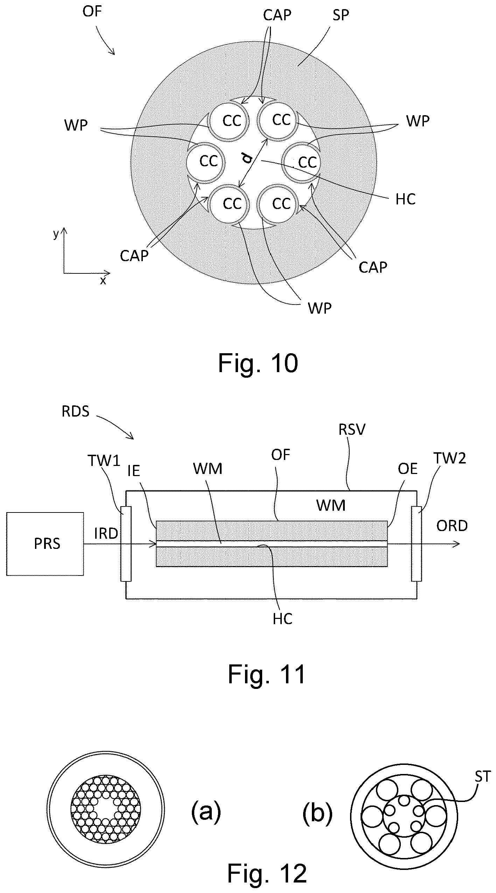

In some implementations, as discussed further below with reference to Figure 11, methods and apparatus for broadening input radiation may use a fiber for confining input radiation, and for broadening the input radiation to output broadband radiation. As such, the fiber may be a non-linear fiber for receiving said pump radiation so as to excite a working medium within the non-linear fiber to generate the broadband or supercontinuum radiation. The fiber may be a hollow core fiber, and may comprise internal structures to achieve effective guiding and confinement of radiation in the fiber. The fiber may be a hollow core photonic crystal fiber (HC-PCF), which is particularly suitable for strong radiation confinement, predominantly inside the hollow core of the fiber, achieving high radiation intensities. The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. The output radiation may

Some embodiments relate to a new design of such a broadband radiation source comprising an optical fiber. The optical fiber is a hollow-core, photonic crystal fiber (HC-PCF). In particular, the optical fiber may be a hollow-core, photonic crystal fiber of a type comprising anti-resonant structures for confinement of radiation. Such fibers comprising anti-resonant structures are known in the art as anti-resonant fibers, tubular fibers, single-ring fibers, negative curvature fibers or inhibited coupling fibers. Various different designs of such fibers are known in the art. Alternatively, the optical fiber may be photonic bandgap fibers (HC-PBFs, for example a Kagome fiber).

A number of types of HC-PCFs can be engineered, each based on a different physical guidance mechanism. Two such HC-PCFs include: hollow-core photonic bandgap fibers (HC-PBFs) and hollow-core anti-resonant reflecting fibers (HC-ARFs). Detail on the design and manufacture of HC-PCFs can be found in US patent US2004/015085A1 (for HC-PBFs) and International PCT patent application WO2017/032454A1 (for Hollow Core anti-resonant reflecting fibers), which are incorporated herein by reference. Figure 12(a) shows a Kagome fiber, comprising a Kagome lattice structure.

An example of an optical fiber for use in the radiation source is now described with reference to Figure 10, which is a schematic cross sectional view of the optical fiber OF in a transverse plane. Further embodiments similar to the practical example of the fiber of Figure 10 are disclosed in WO2017/032454A1.

The optical fiber OF comprises an elongate body, which is longer in one dimension compared to the other two dimensions of the fiber OF. This longer dimension may be referred to as an axial direction and may define an axis of the optical fiber OF. The two other dimensions define a plane which may be referred to as a transverse plane. Figure 10 shows a cross-section of the optical fiber OF in this transverse plane (i.e. perpendicular to the axis), which is labelled as the x-y plane. The transverse cross-section of the optical fiber OF may be substantially constant along the fiber axis.

It will be appreciated that the optical fiber OF has some degree of flexibility and therefore the direction of the axis will not, in general, be uniform along the length of the optical fiber OF. The terms such as the optical axis, the transverse cross-section and the like will be understood to mean the local optical axis, the local transverse cross-section and so on. Furthermore, where components are described as being cylindrical or tubular these terms will be understood to encompass such shapes that may have been distorted as the optical fiber OF is flexed.

The optical fiber OF may have any length and it will be appreciated that the length of the optical fiber OF may be dependent on the application. The optical fiber OF may have a length between 1 cm and 10 m, for example, the optical fiber OF may have a length between 10 cm and 100 cm.

The optical fiber OF comprises: a hollow core COR; a cladding portion surrounding the hollow core COR; and a support portion SP surrounding and supporting the cladding portion. The optical fiber OF may be considered to comprise a body (comprising the cladding portion and the support portion SP) having a hollow core COR. The cladding portion comprises a plurality of anti-resonance elements for guiding radiation through the hollow core COR. In particular, the plurality of anti-resonance elements are arranged to confine radiation that propagates through the optical fiber OF predominantly inside the hollow core HC and to guide the radiation along the optical fiber OF. The hollow core HC of the optical fiber OF may be disposed substantially in a central region of the optical fiber OF, so that the axis of the optical fiber OF may also define an axis of the hollow core HC of the optical fiber OF.

The cladding portion comprises a plurality of anti-resonance elements for guiding radiation propagating through the optical fiber OF. In particular, in this embodiment, the cladding portion comprises a single ring of six tubular capillaries CAP. Each of the tubular capillaries CAP acts as an anti-resonance element.

The capillaries CAP may also be referred to as tubes. The capillaries CAP may be circular in cross section, or may have another shape. Each capillary CAP comprises a generally cylindrical wall portion WP that at least partially defines the hollow core HC of the optical fiber OF and separates the hollow core HC from a capillary cavity CC. It will be appreciated that the wall portion WP may act as an anti-reflecting Fabry-Perot resonator for radiation that propagates through the hollow core HC (and which may be incident on the wall portion WP at a grazing incidence angle). The thickness of the wall portion WP may be suitable so as to ensure that reflection back into the hollow core HC is generally enhanced whereas transmission into the capillary cavity CC is generally supressed. In some embodiments, the capillary wall portion WP may have a thickness between 0.01 - 10.0 µm.

It will be appreciated that, as used herein, the term cladding portion is intended to mean a portion of the optical fiber OF for guiding radiation propagating through the optical fiber OF (i.e. the capillaries CAP which confine said radiation within the hollow core COR). The radiation may be confined in the form of transverse modes, propagating along the fiber axis.

The support portion is generally tubular and supports the six capillaries CAP of the cladding portion. The six capillaries CAP are distributed evenly around an inner surface if the inner support portion SP. The six capillaries CAP may be described as being disposed in a generally hexagonal formation.

The capillaries CAP are arranged so that each capillary is not in contact with any of the other capillaries CAP. Each of the capillaries CAP is in contact with the inner support portion SP and spaced apart from adjacent capillaries CAP in the ring structure. Such an arrangement may be beneficial since it may increase a transmission bandwidth of the optical fiber OF (relative, for example, to an arrangement wherein the capillaries are in contact with each other). Alternatively, in some embodiments, each of the capillaries CAP may be in contact with adjacent capillaries CAP in the ring structure.

The six capillaries CAP of the cladding portion are disposed in a ring structure around the hollow core COR. An inner surface of the ring structure of capillaries CAP at least partially defines the hollow core HC of the optical fiber OF. The diameter d of the hollow core HC (which may be defined as the smallest dimension between opposed capillaries, indicated by arrow d) may be between 10 and 1000 µm. The diameter d of the hollow core HC may affect the mode field diameter, impact loss, dispersion, modal plurality, and non-linearity properties of the hollow core optical fiber OF.

In this embodiment, the cladding portion comprises a single ring arrangement of capillaries CAP (which act as anti-resonance elements). Therefore, a line in any radial direction from a center of the hollow core HC to an exterior of the optical fiber OF passes through no more than one capillary CAP.

It will be appreciated that other embodiments may be provided with different arrangements of anti-resonance elements. These may include arrangements having multiple rings of anti-resonance elements and arrangements having nested anti-resonance elements. Furthermore, although the embodiment shown in Figure 10 comprises a ring of six capillaries, in other embodiments, one or more rings comprising any number of anti-resonance elements (for example 4, 5, 6, 7, 8, 9, 10, 11 or 12 capillaries) may be provided in the cladding portion.

Figure 12(b) shows a modified embodiment of the above discussed HC-PCFs with a single ring of tubular capillaries. In the example of Figure 12(b) there are two coaxial rings of tubular capillaries 21. For holding the inner and outer rings of tubular capillaries 21, a support tube ST may be included in the HC-PCF. The support tube may be made of silica.

The tubular capillaries of the examples of Figure 10 and Figures 12 (a) and (b) may have a circular cross-sectional shape. Other shapes are also possible for the tubular capillaries, like elliptical or polygonal cross-sections. Additionally, the solid material of the tubular capillaries of the examples of Figure 10 and Figures 12 (a) and (b) may comprise plastic material, like PMA, glass, like silica, or soft glass.

Figure 11 depicts a radiation source RDS for providing broadband output radiation. The radiation source RDS comprises a pulsed pump radiation source PRS which comprises any of the pump laser arrangements disclosed and/or described herein; an optical fiber OF (for example of the type shown in Figure 10) with a hollow core COR; and a working medium WM (for example a gas) disposed within the hollow core COR. Although in Figure 11 the radiation source RDS comprises the optical fiber OF shown in Figure 10, in alternative embodiments other types of hollow core optical fiber may be used.

The pulsed pump radiation source PRS is configured to provide input radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is disposed inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is disposed inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF.

The reservoir RSV comprises a second transparent window TW2, forming part of a wall of the reservoir RSV. In use, when the optical fiber OF is disposed inside the reservoir RSV, the second transparent window TW2 is located proximate to an output end OE of the optical fiber OF. The second transparent window TW2 may be transparent for at least the frequencies of the broadband output radiation ORD of the apparatus 120.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 11 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

In this context a window may be transparent for a frequency if at least 50%, 75%, 85%, 90%, 95%, or 99% of incident radiation of that frequency on the window is transmitted through the window.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of filling gas, the nonlinear optical processes can include modulation instability (MI), soliton self-compression, soliton fission, Kerr effect, Raman effect and dispersive wave generation, details of which are described in WO2018/127266A1 and US9160137B1 (both of which are hereby incorporated by reference). Since the dispersion of the filling gas can be tuned by varying the working medium WM pressure in the reservoir RSR (i.e. gas cell pressure), the generated broadband pulse dynamics and the associated spectral broadening characteristics can be adjusted so as to optimize the frequency conversion

In one implementation, the working medium WM may be disposed within the hollow core HC at least during receipt of input radiation IRD for producing broadband output radiation ORD. It will be appreciated that, while the optical fiber OF is not receiving input radiation IRD for producing broadband output radiation, the gas WM may be wholly or partially absent from the hollow core COR.

In order to achieve frequency broadening high intensity radiation may be desirable. An advantage of having a hollow core optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range that solid-core fibers and, in particular, hollow core optical fibers can guide radiation in both the ultraviolet and infrared ranges.

An advantage of using a hollow core optical fiber OF may be that the majority of the radiation guided inside the optical fiber OF is confined to the hollow core COR. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise ultrafast pulses, for example, generated by a laser.

The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The input radiation IRD provided by the pulsed pump radiation source PRS may be pulsed. The input radiation IRD may comprise electromagnetic radiation of one or more frequencies between 200 nm and 2 µm. The input radiation IRD may for example comprise electromagnetic radiation with a wavelength of 1.03 µm. The repetition rate of the pulsed radiation IRD may be of an order of magnitude of 1 kHz to 100 MHz. The pulse energies may have an order of magnitude of 0.1 µJ to 100 µJ, for example 1 - 10 µJ. A pulse duration for the input radiation IRD may be between 10 fs and 10 ps, for example 300 fs. The average power of input radiation IRD may be between 100 mW to several 100 W. The average power of input radiation IRD may for example be 20 - 50 W.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulse pump radiation source PRS parameters may include one or more of: pump wavelength, pump pulse energy, pump pulse width, pump pulse repetition rate, and may be varied by varying the parameters of any one or more of the pump laser heads. Said optical fiber OF parameters may include one or more of: optical fiber length, size and shape of the hollow core 101, size and shape of the capillaries, thickness of the walls of the capillaries surrounding the hollow core. Said working component WM, e.g. filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

Further embodiments are disclosed in the subsequent numbered list of clauses:
1. A supercontinuum radiation source comprising:
   a pump laser arrangement for generating pump radiation and comprising a plurality of pump laser heads,
   each having dimensions no greater than 5cm in any direction;
   a radiation combiner for combining the respective pump radiation from each pump laser head; and
   a non-linear fiber for receiving said pump radiation so as to excite a working medium within the non-linear fiber to generate said supercontinuum radiation.
2. A supercontinuum radiation source as defined in clause 1, comprising a control arrangement for controlling the pump laser arrangement, said control arrangement being configured for non-simultaneous emission of pulses from each pump laser head.
3. A supercontinuum radiation source as defined in clause 2, wherein said controller is operable to selectively activate each individual pump laser head.
4. A supercontinuum radiation source as defined in any preceding clause, wherein each pump laser head has dimensions no greater than 1cm in any direction.
5. A supercontinuum radiation source as defined in any preceding clause, wherein a peak power of each pump laser head is greater than 1kW.
6. A supercontinuum radiation source as defined in any preceding clause, wherein a peak power of each pump laser head is greater than 10kW.
7. A supercontinuum radiation source as defined in any preceding clause, wherein each pump laser head comprises a microchip laser, comprising:
   a pump laser;
   a laser cavity; and
   a gain medium within the laser cavity.
8. A supercontinuum radiation source as defined in clause 7, wherein each pump laser comprises one of: a diode laser, a vertical-cavity surface-emitting laser or a vertical external cavity surface emitting laser.
9. A supercontinuum radiation source as defined in clause 7 or 8, wherein said pump laser heads are integrated into an integrated array
10. A supercontinuum radiation source as defined in clause 9, comprising a common gain medium and/or common laser cavity for some or all of the pump lasers.
11. A supercontinuum radiation source as defined in clause 9 or 10, wherein said pump lasers are integrated on a common substrate.
12. A supercontinuum radiation source as defined in any preceding clause, comprising a lens array having a lens for collecting pump radiation from a respective pump laser head of the plurality of pump laser heads.
13. A supercontinuum radiation source as defined in any preceding clause, wherein the pump laser arrangement comprises more than 3 pump laser heads.
14. A supercontinuum radiation source as defined in any preceding clause, wherein the pump laser arrangement comprises more than 5 pump laser heads.
15. A supercontinuum radiation source as defined in any preceding clause, wherein the pump laser arrangement comprises more than 10 pump laser heads.
16. A supercontinuum radiation source as defined in any preceding clause, wherein the pump laser arrangement outputs a train of laser pulses having a pulse repetition rate greater than 10MHz.
17. A supercontinuum radiation source as defined in any preceding clause, wherein the pulse repetition rate of each pump laser head is less than 5MHz.
18. A supercontinuum radiation source as defined in any preceding clause, wherein the pulse repetition rate of each pump laser head is less than 1MHz.
19. A supercontinuum radiation source as defined in any preceding clause, wherein each pump laser head outputs radiation having the same wavelength.
20. A supercontinuum radiation source as defined in any of clauses 1 to 18, wherein plurality of pump laser heads comprise at least two pump laser heads which output radiation having different wavelengths.
21. A supercontinuum radiation source as defined in any preceding clause, wherein the non-linear fiber is a hollow core or solid core photonic crystal fiber.
22. A supercontinuum radiation source as defined in any preceding clause, comprising a focusing arrangement for focusing the combined radiation from the radiation combiner onto an input facet of the non-linear fiber.
23. A supercontinuum radiation source comprising:
   a pump laser arrangement for generating pump radiation and comprising:
   a plurality of pump laser heads;
   a radiation combiner for combining the respective pump radiation from each pump laser head;
   a non-linear fiber for receiving said pump radiation so as to excite a working medium within the non-linear fiber to generate said supercontinuum radiation; and
   a control arrangement for controlling the pump laser arrangement, said control arrangement being configured for non-simultaneous emission of pulses from each pump laser head.
24. A supercontinuum radiation source as defined in clause 23, wherein said controller is operable to selectively activate each individual pump laser head.
25. A supercontinuum radiation source as defined in clause 23 or 24, wherein each pump laser head has dimensions no greater than 1cm in any direction.
26. A supercontinuum radiation source as defined in any of clauses 23 to 25, wherein a peak power of each pump laser head is greater than 1kW.
27. A supercontinuum radiation source as defined in any of clauses 23 to 26, wherein a peak power of each pump laser head is greater than 10kW.
28. A supercontinuum radiation source as defined in any of clauses 23 to 27, wherein each pump laser head comprises a microchip laser, comprising:
   a pump laser;
   a laser cavity; and
   a gain medium within the laser cavity.
29. A supercontinuum radiation source as defined in clause 28, wherein each pump laser comprises one of: a diode laser, a vertical-cavity surface-emitting laser or a vertical external cavity surface emitting laser.
30. A supercontinuum radiation source as defined in clause 28 or 29, wherein said pump laser heads are integrated into an integrated array
31. A supercontinuum radiation source as defined in clause 30, comprising a common gain medium and/or common laser cavity for some or all of the pump lasers.
32. A supercontinuum radiation source as defined in clause 30 or 31, wherein said pump lasers are integrated on a common substrate.
33. A supercontinuum radiation source as defined in any of clauses 23 to 32, comprising a lens array having a lens for collecting pump radiation from a respective pump laser head of the plurality of pump laser heads.
34. A supercontinuum radiation source as defined in any of clauses 23 to 33, wherein the pump laser arrangement comprises more than 3 pump laser heads.
35. A supercontinuum radiation source as defined in any of clauses 23 to 34, wherein the pump laser arrangement comprises more than 5 pump laser heads.
36. A supercontinuum radiation source as defined in any of clauses 23 to 35, wherein the pump laser arrangement comprises more than 10 pump laser heads.
37. A supercontinuum radiation source as defined in any of clauses 23 to 36, wherein the pump laser arrangement outputs a train of laser pulses having a pulse repetition rate greater than 10MHz.
38. A supercontinuum radiation source as defined in any of clauses 23 to 37, wherein the pulse repetition rate of each pump laser head is less than 5MHz.
39. A supercontinuum radiation source as defined in any of clauses 23 to 38, wherein the pulse repetition rate of each pump laser head is less than 1MHz.
40. A supercontinuum radiation source as defined in any of clauses 23 to 39, wherein each pump laser head outputs radiation having the same wavelength.
41. A supercontinuum radiation source as defined in any of clauses 23 to 39, wherein plurality of pump laser heads comprise at least two pump laser heads which output radiation having different wavelengths.
42. A supercontinuum radiation source as defined in any of clauses 23 to 41, wherein the non-linear fiber is a hollow core or solid core photonic crystal fiber.
43. A supercontinuum radiation source as defined in any of clauses 23 to 42, comprising a focusing arrangement for focusing the combined radiation from the radiation combiner onto an input facet of the non-linear fiber.
44. A metrology device comprising:
   a substrate support for supporting a substrate;
   the supercontinuum radiation source of any preceding clause; and
   an optical system operable to direct the supercontinuum radiation from the supercontinuum radiation source to the substrate.
45. A metrology device as defined in clause 44, wherein said metrology device is operable as scatterometer metrology apparatus.
46. A metrology device as defined in clause 44, wherein said metrology device is operable as a level sensor or an alignment sensor.
47. A lithographic apparatus comprising at least one said metrology device as defined in clause 46 for performing alignment and/or levelling metrology .
48. A lithographic cell comprising the lithographic apparatus of clause 47 and a metrology device as defined in clause 45.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A supercontinuum radiation source comprising:
a pump laser arrangement for generating pump radiation and comprising a plurality of pump laser heads,
each having dimensions no greater than 5cm in any direction;
a radiation combiner for combining the respective pump radiation from each pump laser head; and
a non-linear fiber for receiving said pump radiation so as to excite a working medium within the non-linear fiber to generate said supercontinuum radiation.

2. A supercontinuum radiation source as claimed in claim 1, comprising a control arrangement for controlling the pump laser arrangement, said control arrangement being configured for non-simultaneous emission of pulses from each pump laser head.

3. A supercontinuum radiation source as claimed in claim 2, wherein said controller is operable to selectively activate each individual pump laser head.

4. A supercontinuum radiation source as claimed in any preceding claim, wherein a peak power of each pump laser head is greater than 1kW.

5. A supercontinuum radiation source as claimed in any preceding claim, wherein each pump laser head comprises a microchip laser, comprising:
a pump laser;
a laser cavity; and
a gain medium within the laser cavity.

6. A supercontinuum radiation source as claimed in claim 5, wherein each pump laser comprises one of: a diode laser, a vertical-cavity surface-emitting laser or a vertical external cavity surface emitting laser.

7. A supercontinuum radiation source as claimed in claim 5 or 6, wherein said pump laser heads are integrated into an integrated array

8. A supercontinuum radiation source as claimed in claim 7, comprising a common gain medium and/or common laser cavity for some or all of the pump lasers.

9. A supercontinuum radiation source as claimed in claim 7 or 8, wherein said pump lasers are integrated on a common substrate.

10. A supercontinuum radiation source as claimed in any preceding claim, comprising a lens array having a lens for collecting pump radiation from a respective pump laser head of the plurality of pump laser heads.

11. A supercontinuum radiation source as claimed in any preceding claim, wherein the pump laser arrangement comprises more than 3 pump laser heads.

12. A supercontinuum radiation source as claimed in any preceding claim, wherein the pump laser arrangement outputs a train of laser pulses having a pulse repetition rate greater than 10MHz.

13. A supercontinuum radiation source as claimed in any preceding claim, wherein the pulse repetition rate of each pump laser head is less than 5MHz.

14. A supercontinuum radiation source comprising:
a pump laser arrangement for generating pump radiation and comprising:
a plurality of pump laser heads;
a radiation combiner for combining the respective pump radiation from each pump laser head;
a non-linear fiber for receiving said pump radiation so as to excite a working medium within the non-linear fiber to generate said supercontinuum radiation; and
a control arrangement for controlling the pump laser arrangement, said control arrangement being configured for non-simultaneous emission of pulses from each pump laser head.

15. A metrology device comprising:
a substrate support for supporting a substrate;
the supercontinuum radiation source of any preceding claim; and
an optical system operable to direct the supercontinuum radiation from the supercontinuum radiation source to the substrate.
